# EUROPEAN PATENT APPLICATION

(11) **EP 1 965 404 A2**
(43) Date of publication of application: **03.09.2008**
(21) Application number: 08152128.8
(22) Date of filing: 29.02.2008
(51) Int. Cl.: H01H 59/00

(54) **Circuit system with supply voltage for driving an electromechanical switch**

(30) Priority: 02.03.2007 US 681205
(71) Applicant: General Electric Company, Schenectady, NY 12345 (US)
(72) Inventor: Wright, Joshua Isaac, Arlington, VA 22201 (US); Subramanian, Kanakasabapathi, Clifton Park, NY 12065 (US); Reeves Hedges, Nicole Christine, Albany, NY 12203 (US); Park, John Norton, Rexford, NY 12148 (US)
(74) Representative: Bedford, Grant Richard

(57) **Abstract**

A circuit (10) for controlling operation of a load (16). In one example, a MEMS switch (20) is positioned in the circuit(10) to place the load (16) in one of a conducting state or a nonconducting state. A piezoelectric transformer (46) provides a relatively high voltage output signal or a relatively low voltage output signal to control movement of the switch (20) between a closed position, placing the load in the conducting state, and an open position. The high voltage output signal includes a frequency component in the resonant frequency range of the transformer (46). Control circuitry (65) provides an input voltage signal to the piezoelectric transformer (46) to provide the high voltage output signal or the low voltage output signal at the output terminals of the piezoelectric transformer (46).

## Description

The present invention relates generally to voltage conversion and, more specifically, to circuits and systems incorporating current loads and switches for controlling current flow therein.

Electromechanical switches are typically gated into the conducting or nonconducting states using switched DC voltage supplies or switched AC supplies. Numerous applications require very fast switching characteristics which are attainable with microelectromechanical (MEMS) switches. Such switches have distinct voltage and current characteristics and can attain switching speeds on the order of 3 to 20 microseconds. As switching component sizes continue to shrink, the characteristics of drive circuitry capable of providing acceptable performance and package size is becoming more demanding.

Wire wound electromagnetic transformers are commonly used for voltage conversion in many power circuit applications, including, for example, televisions and fluorescent lamps. In electromagnetic transformers energy is transferred by magnetic coupling between primary and secondary windings. This renders circuitry susceptible to EMI and greater electrical isolation is often desired. Electromagnetic transformers require a large number of conductive wire turns on a magnetic core in order to achieve a high transformation ratio. With trends in power electronics to miniaturize components, the winding process normally results in heavy, bulky devices. Formation of planar transformers on, for example, semiconductor substrates or PCB's is more compact, but remains complex, costly, area intensive, and limits the range of operating power obtainable.

To fully realize the potential benefit of current and future MEMS switch designs, it is desirable to develop switching systems which reliably operate at desired speeds and which can be powered by more efficient circuitry and which can be fabricated in a relatively small volume using existing microelectronics technology.

According to various embodiments of the invention, a circuit is provided for controlling operation of a load. A MEMS switch is positioned in the circuit to place the load in one of a conducting state or a nonconducting state and a piezoelectric transformer provides a relatively high voltage output signal or a relatively low voltage output signal to control movement of the switch between a closed position, placing the load in the conducting state, and an open position, with the high voltage output signal including a frequency component in the resonant frequency range of the transformer. Control circuitry provides an input voltage signal to the piezoelectric transformer to provide the high voltage output signal or the low voltage output signal at the output terminals of the piezoelectric transformer. The ratio of the peak value of the high voltage output signal to the peak value of the input voltage signal may range from 5 to 10.

According to other embodiments of the invention, a circuit for supplying a drive voltage to a MEMS switch includes a piezoelectric transformer having a characteristic resonant frequency with an output terminal of the transformer coupled to the gate electrode. The drive circuitry may be coupled to energize the transformer with a first relatively low voltage signal having a frequency component different from the characteristic resonant frequency, with the first signal having a first peak voltage, in order for the transformer to provide a second signal in response to the first signal, with the second signal also having a frequency component different from the peak resonant frequency, and the second signal having a second peak voltage greater than the first peak voltage. The circuitry may include rectifying circuitry coupled between the transformer output terminal and the gate electrode to convert the second signal into a rectified signal capable of changing the state of the MEMS switch.

According to still other embodiments, a system includes a circuit having a supply voltage, a load and an electromechanical switch having an element moveable to a first position which places the switch in a conducting mode and moveable to a second position which places the switch in a non-conducting mode. The switch further includes a control terminal for selectively applying or removing an electrostatic force to place the element in the first position or in the second position. The high voltage terminal of a piezoelectric transformer is connected to the control terminal and a second terminal of the transformer is connected to receive an input signal so that with application of a first level signal to the second terminal the high voltage terminal provides a high voltage signal to the control terminal of sufficient voltage to generate an electrostatic field which displaces the element from one of the positions to the other position.

In an embodiment of a method for controlling operation of a load, a circuit is formed with a MEMS switch positioned to place the load in one of a conducting state or a nonconducting state and a piezoelectric transformer having a resonant frequency range with a peak resonant frequency. A relatively high voltage output signal or a relatively low voltage output signal is provided to output terminals of the piezoelectric transformer to control movement of the switch between a closed position and an open position, with the high voltage output signal including a frequency component in the resonant frequency range of the transformer. The input terminals of the piezoelectric transformer may be driven according to a control signal to selectively provide the high voltage output signal or the low voltage output signal at the output terminals of the piezoelectric transformer.

According to embodiments of a method for optimizing rise and fall times of output voltages from a piezoelectric transformer, which may be coupled to drive a MEMS switch between conducting and nonconducting states, the transformer is energized with an input signal having a frequency that is offset with respect to the transformer's resonant frequency to produce a high voltage output signal. The output signal is rectified and the rectified signal is applied to drive the MEMS switch from one of the conducting and nonconducting states to the other state. In some embodiments the peak value of the output signal produced in response to a peak value of the input signal is greater than the peak value of the input signal.

Various aspects and embodiments of the invention will be more clearly understood from the following description wherein embodiments are illustrated, by way of example only, with reference to the accompanying drawings; in which:
FIG 1 illustrates an exemplary circuit having a MEMS switch under the control of PZT and associated drive circuitry to switchably control flow of current through a load ;
FIG 2 illustrates an exemplary arc-less MEMS based switching system also having a MEMS switch under the control of a PZT and associated drive circuitry to switchably control flow of current through a load; and
FIG 3 illustrates an equivalent circuit corresponding to the PZT the illustrated in FIGS 1 and 2.

Like reference numbers are used throughout the figures to indicate like features. Individual features in the figures may not be drawn to scale.

Presently, Microelectromechanical Systems (MEMS) generally refer to micron-scale structures that can, for example, integrate a multiplicity of diverse elements, e.g., mechanical elements, electromechanical elements, sensors, actuators, and electronics, on a common substrate through micro-fabrication technology. Switch technology used for MEMS applications includes semiconductor devices such as power Field Effect Transistors (FETs) and Insulated Gate Bipolar Transistors (IGBTs), but also includes MEMS switches which are electromechanical in nature. One example of a MEMS switch includes a gate electrode controlling an electrostatically actuated beam. The beam is displaceable between two positions to render the switch in either a conductive or a non-conductive state.

Such MEMS switches have substantially different requirements than semiconductor switches which typically require a low voltage actuating gate drive, e.g., less than 18V. Present MEMS switches, on the other hand, require a relatively high voltage (50 to 100V) to achieve desired switching characteristics when driving the switch between on and off states. The gate electrodes of a MEMS switch are also characterized by very low actuating current due to their relatively small inter-electrode capacitance, e.g., 3 - 30 pf.

A feature of the embodiments described in the figures is the incorporation into Microelectromechanical Systems of a piezoelectric transformer (referred to herein as a PZT) which utilizes the piezoelectric effect to provide an ac voltage conversion. The PZT may be coupled to receive a low voltage signal and generate a high voltage gate drive pulse suitable for operation of a MEMS switch. Examples include operation of a MEMS switch for controlling current through a simple load, and a specialized circuit implementation for arc-less switching such as may be used in motor start-up circuits. However, the concepts presented are applicable to a wide variety of additional switching applications. Further, it is noted that many techniques and structures presently available in MEMS devices will in just a few years be available via nanotechnology-based devices, e.g., structures that may be smaller than 100 nanometers in size. Even though example embodiments described throughout this document may refer to micron-scale MEMS-based devices, it is to be understood that the invention contemplates these and other advances and should be broadly construed without being limited to micron-sized devices. Accordingly, the term Microelectromechanical Systems (MEMS) as used herein is not limited to micron-scale structures but, rather, also refers to systems incorporating structures that are smaller than the micron-scale. The term MEMS switch contemplates any electromechanical switch having a structure on the micron scale or smaller, and reference to specific MEMS switch designs or specific products is only exemplary.

Although specific examples of PZTs are described, it is to be understood that many of the wide variety of PZT designs may be used when practicing the invention. By way of example, ceramic-based Rosen-type PZTs are illustrated in the embodiments, but use of other types of PZTs is contemplated and the use of other materials suitable for PZT operation is also contemplated. In describing characteristics of components and operation of the systems or circuits, the terms rise time and fall time as applied to control parameter waveforms are used in a conventional manner, understood to mean lapsed time in transition between 10 percent and 90 percent of a peak value. Also, as used herein, resonant frequency band is understood to be the frequency range over which a PZT exhibits useful mechanical responsiveness, and resonant frequency is understood to mean a specific frequency exhibiting a maximum value of mechanical or electrical responsiveness.

The application of a PZT to drive the gate electrode of a MEMS switch is to be distinguished from other possible gate drive applications. Unlike low voltage gate drives (less than 18V) required for IGBT and FET applications, MEMS switches require a relatively high voltage supply (50-100V) suitable for rapid and reliable closure of the micro-mechanical switch contacts. The individual MEMS gates can exhibit a relatively low level of capacitance, typically on the order of 3 to 30pF and generally less than 100 pf, such that operation requires only a very small, e.g., microamperes or less, instantaneous current pulse to charge the gate structure. Thus only a few milliwatts of average power are typically needed to supply a multi-megohm level gate-to-source impedance.

In a MEMS switching system such a high voltage (50 - 100V), fast response gate driving signal can be realized by coupling the output of a PZT to a fast full wave diode bridge rectifier. Furthermore, to the extent required, voltage regulation functions may be implemented based on the resonant mode characteristics of the PZT via variable frequency control. The MEMS switching system utilizing an appropriately designed PZT for converting a low input switching signal to a high gate voltage can be operated in pulsed mode for fast turn-on and turn-off of the high voltage output without requiring additional timing circuitry on the high voltage side. Rectification of the output voltage signal from the PZT provides a high voltage pulse signal without requiring high voltage logic circuitry. The foregoing enables generation of a rectified high voltage DC output having very fast rise and fall times. Rise and fall times can easily be on the order of 3 - 30 microseconds, achieving very fast high voltage turn-on and turn-off times of a MEMS switch. The input signal to the PZT can be at a fixed frequency within the mechanically resonant frequency band of the device, and logic controlling the low voltage input signal effectively controls the high voltage PZT output. That is, the high voltage gate signal (e.g., 90V) can be rapidly switched on or rapidly switched off with low voltage logic. The high output voltage signal (i.e. 90V) having fast turn-on and turn-off response times can rapidly place the MEMS switch into or out of conduction on demand. Thus, with switching completely controlled by logic on the low voltage side of the transformer, there is no need to incorporate complex and isolated high voltage logic circuitry to control the input to the gate of the MEMS switch as provided by the high voltage output terminals of the PZT . The input signal frequency can be at or offset from the specific resonant frequency of the PZT by 30 to 40 percent although deviations on the order of five to 10 percent, or less, are also contemplated. With the input to the PZT being capacitative when operated at frequencies below the specific resonant frequency, an inductive element may be placed in series between the PZT driver circuitry and one of the PZT input terminals to optimize the switching performance.

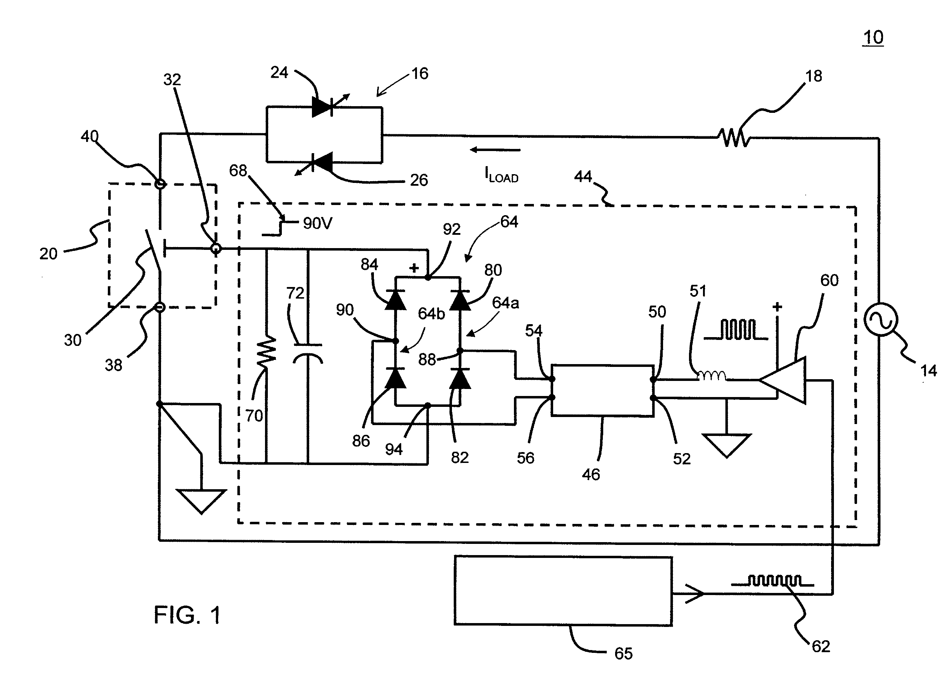

With reference to FIG 1 there is shown a circuit 10 having a supply 14 in series with an exemplary lamp load 16 and a current limiting load resistor 18. A switch 20 is positioned to control flow of current I_{Load} through the circuit. In this example, the supply 14 is an alternating voltage source. The lamp load 16 in this example comprises a pair of light emitting diodes 24 and 26 configured in anti-parallel relationship with one another, i.e., oriented to conduct current in opposite directions. The switch 20 is a micro-electromechanical systems (MEMS) three terminal switch and may, as schematically illustrated, be of the type having an electrostatically actuated beam 30 coupled to a control or gate electrode 32 to selectively pass load current between a source electrode 38 and a drain electrode 40. The switch is positioned in series with the supply 14 and the lamp load 16 having the source electrode 38 coupled to the supply 14 and the drain electrode 40 coupled to the lamp load 16.

Current flow through the MEMS switch 20 is controllable by application of a voltage to the gate electrode 32 and removal of the voltage from the gate electrode 32. Unlike semiconductor switches, e.g., Insulated Gate Bipolar Transistors (IGBTs) or Field Effect Transistors (FETs), MEMS switches, including the switch 20, generally require a low current, high voltage driving signal commonly ranging between 40 and 100 volts. To effect selective application of the driving signal, a gate driver system 44 is connected to the gate electrode 32 of the MEMS switch 20.

The system 44 includes a piezoelectric transformer (PZT) 46, which receives a low voltage input signal in a frequency range of about 30 - 100 kHz across a pair of input terminals and provides a high voltage AC output signal across a pair of output terminals. Thus the illustrated transformer 46 is a four terminal device, having a low voltage signal input electrode 50 with an associated ground input electrode 52, and a high voltage output electrode 54 with an associated ground output electrode 56. In this example, the ground electrodes 52 and 56 are isolated from one another, while in other embodiments the transformer 46 could be replaced with a three terminal device wherein the input and output terminals share a common ground. Generally, for this and other embodiments, the voltage across the PZT output terminals, e.g., 54, 56 is referred to as the PZT output voltage V_{PO}. For the signal input to the transformer 46, a low voltage input driver circuit 60 receives, for example, a 40 kHz low voltage signal 62 in the range of zero to 5 volts. The illustrated signal 62 may be generated as on/off square wave pulses which collectively form a modulated square wave pulse-train, by switching control circuitry 65 that includes a 40 kHz square wave generator. Each on-pulse to the PZT is modulated at the 40 kHz frequency. The driver circuit 60 provides a suitable input signal across the PZT input electrodes 50, 52, for example, on the order of 15V volts peak-to-peak at the 40 kHz frequency.

By way of example, the transformer 46 may be of the Rosen type, having a 1 W output rating and a resonant frequency of 100 kHz. Such devices, as manufactured by Face Electronics, L.C. of Norfolk, Va. U.S.A., may exhibit significant capacitance at the input terminals (e.g., 70 - 80 nF), requiring a very short duration instantaneous peak input current greater than 1A at the operating frequency but whose average current is a small fraction of an Ampere during the pulse train. A suitable driver circuit capable of providing an input voltage on the order of 15 volts peak-to-peak to the transformer 46 is the MIC4428 manufactured by Micrel, Inc. of San Jose, Ca. USA. With such an input signal the transformer 46 can provide a peak output signal at the operating frequency across the electrodes 54, 56 on the order of 90 volts peak-to-peak.

The output AC voltage across the electrodes 54 and 56 is coupled to a conventional full wave diode bridge 64, having first and second parallel branches 64a and 64b, to provide a fully rectified waveform which results in a relatively stable DC gate pulse signal 68 during the duration of the AC pulse. The first branch 64a includes first and second diodes 80, 82 in series and the second branch 64b includes third and fourth diodes 84, 86 in series. A first bridge input terminal 88, between the diodes 80, 82 is connected to the output terminal 54, while a second bridge input terminal 90, between the diodes 84, 86 is connected to the output terminal 56. A first bridge output terminal 92, positioned between the diodes 80 and 84, is connected to the MEMS switch gate electrode 32 while a second bridge output terminal 94, positioned between the diodes 82 and 86, is tied to the source electrode 38.

A filter stage includes, in parallel configuration, a resistor 70 and a capacitor 72 each positioned across the switch terminals 32 and 38, and having values selected to adjust rise and fall times of the rectified gate pulse signal 68 to achieve desired switching rise and fall times. The rectified signal 68 between the gate electrode 32 and the source electrode 38 has an on-voltage of about 90 volts which is selectively applied, by the timing action of the switching circuitry 65, to operate the MEMS switch 20.

According to other embodiments, a gate driver system such as the system 44 may control switching of two or more MEMS switches arranged in parallel to increase the load capacity of the switching operation. In still other applications, multiple MEMS switches 20 may be positioned in parallel configuration such that all of the gates are connected in parallel and driven by the gate driver system 44, all under the control of the same switching circuitry 65. For some applications it may be preferable to use commonly driven but individual driver systems 44 to drive each gate of the parallel combination of switches.

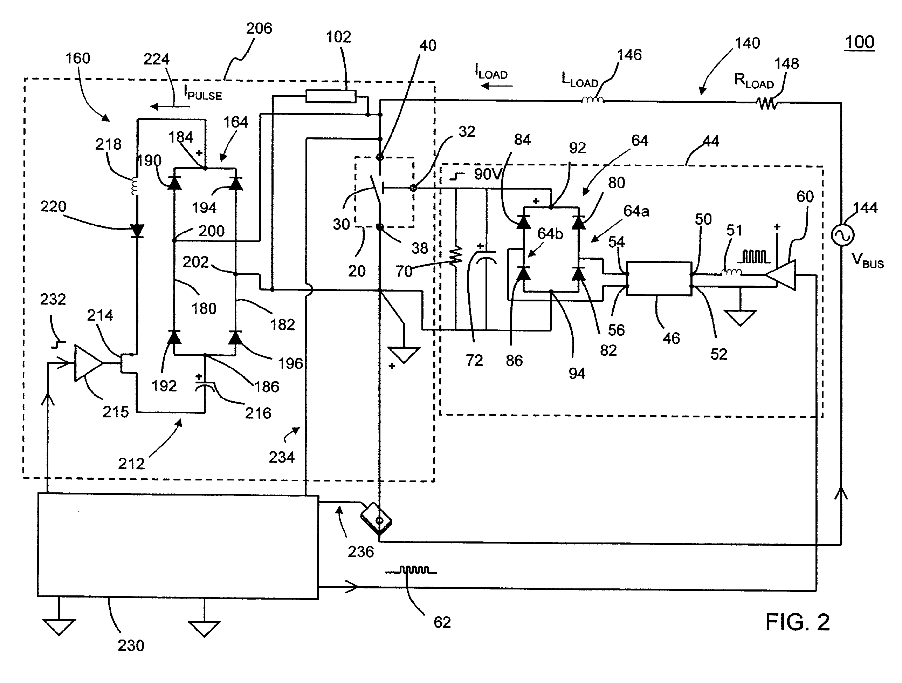

Turning now to FIG 2, an exemplary arc-less MEMS based switching system 100 is illustrated in accordance with another embodiment. The system 100 includes one or more MEMS switches 20 positioned in a load circuit 140. For simplicity of illustration only a first switch 20 is illustrated.

The switching system 100 senses current or voltage levels in a load circuit operable under the control of a MEMS switch. If the current or voltage level exceeds a threshold, a fault signal is generated and applied to trigger a pulse current in a pulse circuit 212 containing a balanced diode bridge. The pulse current via the action of the balanced diode bridge 182 connected appropriately across the MEMS switch 20 enables diversion of current from the MEMS switch in order to reduce or eliminate arcing prior to opening of the MEMS switch.

The pulse circuit 212 is positioned to detect a switch condition for the MEMS switch 20 as more fully explained herein. Logic and driver control circuitry 230 includes voltage sensing circuitry 234 coupled to the drain 40 of the switch 20 and current sensing circuitry 236 coupled to the circuit 140. The sensing circuitry 234 and 236 may detect, for example, when a voltage or current level in the circuit 140 exceeds a predetermined threshold, in response to which the circuitry 230 triggers the pulse circuit 212. In the illustrated embodiment, the gate electrode 32 of the MEMS switch 20 is controlled to selectively pass load current I_{load} between the source electrode 38 and the drain electrode 40. The gate electrode 32 is driven by the gate driver system 44 as described with reference to FIG 1. In this example, the gate driver system 44 receives on-off pulsed square wave signals 62 from the logic and driver control circuitry 230.

Voltage snubber circuitry 102 may, as illustrated, be coupled in parallel with the MEMS switch 20 and configured to limit the reapplied voltage rate-of-rise during fast contact separation. In certain embodiments, the snubber circuitry 102 may include a snubber capacitor (not shown) coupled in series with a snubber resistor (not shown). The snubber capacitor may facilitate slowdown of the reapplied contact voltage as mentioned above. Furthermore, the snubber resistor may suppress any pulse of current generated by the snubber capacitor during the closing of the MEMS switch 20. In certain other embodiments, the voltage snubber circuitry 102 may include a metal oxide varistor (MOV) (not shown).

The load circuit 140, connected in series with the MEMS switch 20, includes a voltage source 144 (*V_{BUS}*), a load inductance 146 (*L_{LOAD}*) representative of a combined load inductance and a bus inductance viewed by the load circuit 140, and a load resistance 148 (*R_{LOAD}*) representative of a combined load resistance viewed by the load circuit 140. A load circuit current *I_{LOAD}* may flow through the load circuit 140 under the control of the first MEMS switch 20.

Arc-less suppression circuitry 160, for protecting the switch 20, includes a balanced diode bridge 164 configured with first and second branches 180, 182 coupled across nodes 184 and 186, each branch when pulsed exhibiting substantially equal voltage drops across the diodes 190 and 194 so that the voltage across nodes 200 and 202 is close to zero. The first branch 180 of the bridge 164 includes a first diode 190 and a second diode 192 coupled together in series. The second branch 182 of the bridge 164 includes a third diode 194 and a fourth diode 196 also coupled together in series. The arc-less suppression circuitry 160 may be modified or expanded to facilitate suppression of arc formation between contacts of multiple MEMS switches.

The MEMS switch 20 is arranged in parallel configuration across a pair of first terminals 200, 202 of the bridge 164. One of the first terminals 200 is positioned between the first and second diodes 190, 192 and a second of the first terminals 202 is positioned between the third and fourth diodes 194, 196. When transferring load current to the diode bridge 164 during turn-off of the MEMS switch 20, the inductance between the MEMS switch 20 and the diode bridge 164 produces a relatively small *di*/*dt* voltage, e.g., less than two to five percent of the voltage across the source 38 and drain 40 of the MEMS switch when in forward conduction. The MEMS switch 20 may be integrated with the balanced diode bridge 164 in a single package 206 or, optionally, formed on the same die in order to minimize the aformentioned inductance between these components.

A switch condition may occur in response to a number of actions including but not limited to a circuit fault or a switch ON/OFF signal. The pulse circuit 212 includes, in series arrangement, a pulse switch 214, a pulse capacitor *C_{PULSE}* 216, a diode bridge 164, a pulse inductor *L_{PULSE}* 218 and a diode 220. The switch 214 may be a solid state device, such as a field effect transistor, configured to have switching speeds in the range of nanoseconds to microseconds. The diode bridge 164 is positioned in the pulse circuit 212 to provide a nearly zero voltage drop across the drain 40 to source 38 of the switch 30 when it is pulsed in response to an overcurrent or an on/off command from the control circuit 230. As already described, the pulse command is generated by the control circuit 230 in response to a sensed overcurrent condition by sensor 236. In this example, the pulse switch 214 is schematically shown to be a three terminal device having a gate terminal coupled to a driver circuit 215 under the control of the logic and driver control circuitry 230. Reference numeral 224 is representative of a pulse circuit current *I_{PULSE}* that may flow through the pulse circuit 212 during a switch transition. The pulse capacitor 216, pulse inductor 218 and diode 220 are selected to facilitate pulse current shaping and timing based on characteristics of the fault current sensed by sensor 236. Pulse switch 214 and it's associated driver and control circuitry provide the interface between the control circuit 230 and the pulse switch driver 215.

The MEMS switch 20 may be rapidly switched (e.g., on the order of one to 30 microseconds) between a closed state and an open state while carrying current at a near-zero drain to source voltage. The gate electrode 32 is controlled by the circuitry 230 which can issue the on-off control signal 62, e.g., either a 40 kHz high level signal or a low level signal. The signal 62 is generated by the control circuit 230 in response to a detected overcurrent or fault current in the load circuit by sensor 236.

The logic and driver control circuitry 230 and the voltage and current sensing circuitry 234, 236 detect a load fault when, for example, a voltage or current level in the load circuit 140 exceeds a predetermined threshold. In response to a load fault the pulse circuit 212 facilitates switching the MEMS switch from a closed state to an open state. The circuitry 230 triggers the pulse switch 214 to a closed position via the driver circuit 215 to pulse the bridge. The trigger may be due to a fault condition generated due to an excessive current level in the circuit 140, but may also be based on a monitored ramp voltage in order to achieve a given system-dependent on-time for the MEMS switch 20.

In the embodiment shown in FIG. 2, the control circuitry 230, upon detection of a fault or an external command, sends a trigger signal 232 to the driver circuit 215 to operate the pulse switch 214. In response the switch 214 may, for example, generate a sinusoidal pulse responsive to a detected switching condition. The triggering of the pulse switch 214 then initiates a resonant half sinusoid of current in the pulse circuit 212.

The peak value of the half sinusoidal bridge pulse current 224 (*I_{PULSE}*) is a function of the initial voltage across the pulse capacitor *C_{PULSE}* 216 as well as the value of the pulse capacitor 216 (*C_{PULSE}*) and the pulse inductance 218 (*L_{PULSE}*). The values of the pulse inductor 218 and the pulse capacitor 216 also determine the pulse width of the half sinusoid of pulse current. The bridge current pulse width and amplitude may be adjusted to meet the system load current turn-off requirement predicated upon the rate of change of the load current *(V_{BUS}* /*L_{LOAD})* and the desired peak let-through current during a load fault condition. According to the embodiment of FIG 2, the pulse switch 214 is reconfigured from an open state to a closed, conducting state prior to opening the MEMS switch 20.

Under a fault condition, with the logic and control circuitry having issued a trigger signal 232, the amplitude of the pulse circuit current 224 *(I_{PULSE}*) becomes appreciably greater than the amplitude of the load circuit current *I_{LOAD}* (e.g., due to resonance in of the pulse circuit 212 and the initial voltage on capacitor 216). Concurrently, with a voltage applied to the gate electrode 32 by the MEMS gate driver system 44, the operating state of the MEMS switch 20 is transitioned from a closed and conducting state to one of increasing resistance as the MEMS switch 20 starts to turn off. During this transition contacts between the beam 30 and the drain region may still be closed, but contact pressure is diminished due the switch opening process. This causes the switch resistance to increase which, in turn, diverts the load current from the MEMS switch 20 into the diode bridge 164. In this state, the balanced diode bridge 164 provides a path of relatively low impedance to the load circuit current *I_{LOAD} ,* relative to a path through the MEMS switch 20, which exhibits an increasing contact resistance. Diversion of load circuit current *I_{LOAD}* through the MEMS switch 20 is an extremely fast process compared to the rate of change of the load circuit current *I_{LOAD}.* To further increase the rate of current diversion the inductances associated with connections between the MEMS switch 20 and the balanced diode bridge 164 should be minimized.

With the load circuit current *I_{LOAD}* diverted from the MEMS switch 20 to the diode bridge 164, an imbalance forms across the first and second diode branches 180, 182. As the pulse circuit current decays, voltage across the pulse capacitor 212 (*C_{PULSE}*) continues to reverse (e.g., acting as a "back electro-motive force") causing reduction of the load circuit current *I_{LOAD}* to zero. The diodes 192 and 194 become reverse biased such that the pulse inductor 218 *L_{PULSE}* and the bridge pulse capacitor 216 (*C_{PULSE})* render the load circuit 140 a series resonant circuit including the effect of the load inductance.

The diode bridge 164 may be configured to maintain a near-zero voltage across the contacts of the MEMS switch 20 until the contacts separate to open the MEMS switch 20, thereby preventing damage by suppressing any arc that would tend to form between the contacts of the MEMS switch 20 during opening. The contacts of the MEMS switch 20 approach the opened state with a much reduced contact current through the MEMS switch 20. Also, any stored energy in the circuit inductance, the load inductance and the source may be transferred to the pulse circuit capacitor 212 (*C_{PULSE}*) and may be absorbed via voltage dissipation circuitry (not shown).

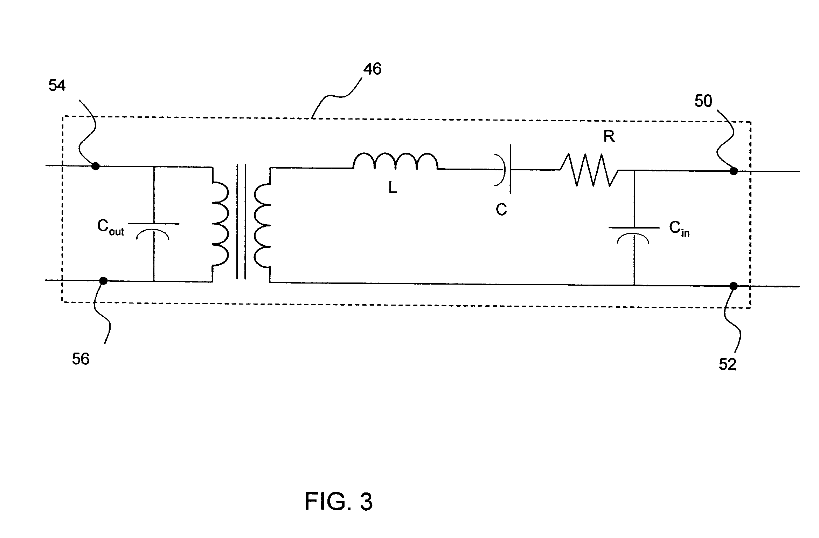

FIG 3 illustrates an exemplary equivalent circuit for the piezo-electric transformer 46 of FIGS 1 and 2. When a one watt PZT transformer such as manufactured by Face Electronics, L.C. is used as the transformer 46, with the following component values, a 15v input on-voltage from the driver circuit 60 results in a 90v output V_{PO} across the terminals 54, 56:

| | |
|---|---|
| Cᵢₙ: 74.3 nF | R: 1.20 Ohms |
| C: 1.34 nF | L: 1.42 mH |
| Cₒᵤₜ: 10.4 pF | Output Voltage/Input Voltage (Peak): 6 |

Example applications of a switching system have been illustrated. The circuits incorporate a MEMS switch of the type having a movable element responsive to an electrostatic force. During operation one or more MEMS switches are placed in a normally closed, conductive state to continuously pass current through a load for a relatively long period of time, e.g., minutes, days, months or a year. The switch usually and predominantly remains in a conductive mode. For the exemplary arc-less MEMS based switching system 100 of FIG 2, occurrence of an abnormal condition, such as a short circuit, results in an immediate, high speed turn-off response effected with rapid transition in the PZT output voltage V_{PO}. The lapsed time between detection of the fault and placing the switch 20 in the non-conductive state can be on the order of a few microseconds more than the minimum switching time of the PZT drive circuitry.

Numerous embodiments of the invention are characterized by a very low average switching power relative to other power switching applications. For example, some power conversion applications utilize relatively low voltage (often less than 18 volts) semiconductor switching devices to provide continuous high speed switching on the order of 100 kHz or higher.

In such continuous high frequency applications average switching losses are relatively large. Furthermore, MEMS switches such as incorporated in the systems 10 and 100 exhibit capacitance characteristics about three orders of magnitude smaller than semiconductor switches designed for comparable circuit applications. As a result, for a given switching speed the power required to operate the MEMS switch is also much lower.

Another feature of the example systems 10 and 100 is the design of the circuitry to use the PZT in a manner which minimizes the rise and fall time of the PZT output voltage across the terminals 54 and 56 without requiring optimizations for efficiency and low power dissipation. Power dissipation during individual switching operations may be of greater concern when the MEMS switch is deployed in a circuit which maintains the switch in an on-state for long periods of time, rather than undergoing high frequency cycling through on-off states. PZTs have a sharp resonant frequency characteristic of the output voltage to input voltage ratio. The resonant frequency depends on the material constants and the dimensions of the materials involved in the construction of the transformer, including the piezoelectric layers and electrodes.

To effect high speed transitions the PZT device receives input signals 62 at other than the peak resonant frequency of the device. For example, with the PZT 46 having a peak resonant frequency of 100 kHz +/- 10 %, the input signal across the terminals 50 and 52 is at 40 kHz based on the signal 62 generated from the switching control circuitry 65 or the logic and driver control circuitry 230. That is, the circuit 10 and the system 100 are designed to operate the PZT 46 at frequency which other than the peak resonant frequency and therefore at a relatively low efficiency. This results in damping to effect fast turn-off while the loss in efficiency is tolerable in the example applications. For other circuit embodiments optimization of speed may involve selection of a PZT having a higher resonant frequency and the input signal to the PZT may be relatively close to the resonant frequency. Generally, the resonant frequency may range from 100 kHz to at least 500 kHz and the input signal can vary from the resonant frequency by 10 - 40 percent or more.

The optimum PZT may operate with a relatively low dissipation factor (mechanical Q), a high operating frequency of 100 kHz or more, and close to the resonant frequency. Operational mode is enhanced by compensating the input capacitance of the PZT device with an inductive load such as the inductor 51 placed between a PZT input terminal 50 and the driver circuitry 60 of FIG 1 or FIG 2. The ratio of peak output to peak input voltage for a PZT in a MEMS gate driver can be on the order of 5:1 to 10:1 1 or higher. The driver circuitry may generate an input signal to the PZT on the order of 5 to 15 volts while the PZT output voltage may be on the order of up to 100 volts or more.

The disclosed embodiments provide a MEMS gate driver with very high voltage isolation between input and output terminals, very low input-output capacitive coupling, high frequency operation, low EMI production and a high ratio of output voltage to input voltage. Examples have been used to illustrate the invention, including the best mode, and to enable persons skilled in the art to make and use the invention. Numerous other embodiments are contemplated and the scope of the invention is only limited by the claims which follow.

## Claims

1. An electrical system including a circuit (10) for controlling operation of a load (16) comprising:
a MEMS switch (20) positioned to place the load (16) in one of a conducting state or a nonconducting state;
a piezoelectric transformer (46) having a resonant frequency range with a resonant frequency and configured to provide a relatively high voltage output signal or a relatively low voltage output signal from output terminals (54, 56) thereof to control movement of the switch (20) between a closed position, placing the load in the conducting state, and an open position, placing the load in the nonconducting state, the high voltage output signal including a frequency component in the resonant frequency range of the transformer (46); and
control circuitry (65) for providing an input voltage signal to drive input terminals of the piezoelectric transformer (46) to selectively provide the high voltage output signal or the low voltage output signal at the output terminals (54, 56) of the piezoelectric transformer.

2. The circuit (10) of claim 1 wherein the relatively high voltage output signal is **characterized by** a peak output value and the input voltage signal is **characterized by** a peak input value and the ratio of the peak output value to the peak input value ranges from 5 to 10.

3. The circuit (10) of any preceding claim wherein:
the transformer (46) has a resonant frequency range having a specific resonant frequency within that range that produces a peak mechanical response and a peak output voltage response and, the signal provided by the control circuitry includes an oscillating frequency resulting in the relatively high voltage input signal having an oscillating signal within the resonant frequency range of the transformer, so that the transformer provides the relatively high voltage output signal with said frequency component and with a peak value greater than a peak value of the relatively high voltage input signal.

4. The circuit (10) of any preceding claim wherein the signal provided by the control circuitry (65) includes a logic high voltage level corresponding to the relatively high voltage input signal and wherein the relatively high voltage input signal is an oscillating signal with a peak value corresponding to a peak value of the logic high control signal, and the peak value of the relatively high voltage input signal is greater than a peak value of the logic high voltage level of the signal provided by the control circuitry (65).

5. The circuit (10) of any preceding claim wherein the control circuitry (65) is connected to drive circuitry (60) to generate the relatively low input signal and the relatively high input signal, resulting in generation of the peak value of the relatively high voltage input signal exceeding 5 volts.

6. The circuit (10) of any preceding claim wherein the transformer (46) has a resonant frequency range with a specific resonant frequency that produces a peak mechanical response and a peak output voltage response and provision of the relatively high voltage input signal is performed by creating the relatively high voltage input signal based on a signal from the control circuitry (65) having an oscillating frequency within the resonant frequency range of the transformer (46).

7. The circuit (10) of any preceding claim wherein the control circuitry (65) provides the signal at an oscillating frequency offset from the resonant frequency of the piezoelectric transformer (46).

8. The circuit (10) of any preceding claim further including circuitry (64) to rectify the high voltage output signal, said circuit (10) capable of providing an input to the MEMS switch (20) **characterized by** a rise time, measurable from 10 percent of the maximum voltage to 90 percent of the maximum voltage, in the range of one to 30 microseconds.

9. The circuit of any preceding claim further including diode bridge circuitry (64) to rectify the high voltage output signal, said circuit capable of providing an input to the MEMS switch **characterized by** a fall time, measurable from 90 percent of the maximum voltage to 10 percent of the maximum voltage, in the range of three to 10 microseconds.
